# EUROPÄISCHE PATENTSCHRIFT

(11) **EP 0 757 489 B1**
(45) Veröffentlichungstag und Bekanntmachung des Hinweises auf die Patenterteilung: **06.03.2002**
(21) Anmeldenummer: 96111459.2
(22) Anmeldetag: 16.07.1996
(51) Int. Cl.: H04N 7/20, H04N 7/10

(54) **Satelliten-Empfangsanlage mit steuerbarer Kopfstation**
Satellite receiver with a controllable head end
Récepteur satellite avec une tête dirigeable

(30) Priorität: 03.08.1995 DE 19528589
(43) Veröffentlichungstag der Anmeldung: 05.02.1997
(73) Patentinhaber: Kathrein-Werke KG, 83022 Rosenheim (DE)
(72) Erfinder: Ilsanker, Anton, 83083 Riedering (DE); Flinner, Udo, 83026 Rosenheim (DE)
(74) Vertreter: Flach, Dieter Rolf Paul, Dipl.-Phys.

(56) Entgegenhaltungen:
- WO-A-91/06159
- DE-A- 4 012 657
- DE-U- 9 306 499
- GB-A- 2 279 208
- PATENT ABSTRACTS OF JAPAN vol. 095, no. 005, 30. Juni 1995 & JP 07 046586 A (TOSHIBA CORP), 14. Februar 1995

## Beschreibung

Die Erfindung betrifft eine Satelliten-Empfangsanlage mit einer steuerbaren Kopfstation nach den Oberbegriffen der Ansprüche 1 oder 2.

Grundsätzlich sind Satelliten-Einzelempfangsanlagen und sog. Mehrteilnehmeranlagen zu unterscheiden.

Bei sog. Mehrteilnehmeranlagen wird beispielsweise im Rahmen der Satellitenempfangsanlagen eine Sternverteilung mit Schaltmatrix verwendet, worüber dem einzelnen Teilnehmer kein festgelegtes Programmpaket permanent angeboten wird, sondern worüber jeder Teilnehmer die Möglichkeit erhält, sich sein Programmangebot selbst auszuwählen. D.h. er kann zwischen den in der Regel beiden Polarisationen (oder beispielsweise auch den vier Polarisationen unter entsprechender Berücksichtigung der links und rechts zirkularpolarisierten Wellen) eines Satelliten oder zwischen zwei (oder mehreren) Satellitenempfangsantennen umschalten, um die hierüber ausgestrahlten Programme zu empfangen.

Schließlich sind darüber hinaus auch zur Versorgung mehrerer Teilnehmer Satelliten-Signalaufbereitungen nach Art von Kopfstationen bekannt geworden.

Eine derartige Kopfstation ist beispielsweise aus der Vorveröffentlichung DE-Z Antennen - für den Satellitenempfang", Thurl/Ilsanker, Franzis Arbeitsbuch, 1991, Seite 83 bis 85 bekannt.

Die dort beschriebene Kopfstation umfaßt beispielsweise sechs Kanalzüge, die eine Programmauswahl aus zwei unterschiedlichen Polarisationen bzw. von zwei Satelliten und die Einspeisung in ein UHF-taugliches Verteilnetz zeigt. Mit dem Eingangssammelfeld wird die freie Beschaltung der Eingänge der Kanalzüge in der Zwischenfrequenz-Ebene ermöglicht, so daß sechs beliebige Programme aus dem gesamten Angebot ausgewählt werden können. Im Ausgangssammelfeld werden die UHF-Kanäle zusammengefaßt. Die Einstellung der Ein- und Ausgangskanäle erfolgt durch einen Mikroprozessor. Dabei ist die Satellitenkompaktaufbereitung modular aufgebaut, d.h. die Demodulatoren und Modulatoren werden als Einheiten gefertigt, geprüft und dann in das Gerät integriert.

In Abweichung zu der vorstehend erläuterten Kopfstation sind aber grundsätzlich auch sog. "steuerbare Kopfstationen" bekannt geworden, worüber die angeschlossenen Teilnehmer über ihren Receiver oder ein Zusatzmodul bestimmte Programme aus dem angebotenen und empfangenen Programmspektrum auswählen können.

Dazu ist eine Außeneinheit mit einer Antenne und in der Regel einem Konverter (einschließlich einer Polarisationsweiche) vorgesehen, worüber ein oder mehrere Polarisationen oder die von einem oder mehreren Satelliten empfangenen Signale (beispielsweise über ein Multifeed-Speisesystem) einer Umschalteinheit zugeführt werden, die mit entsprechender Anzahl von Eingängen und schaltbaren Ausgängen zumindest in Höhe der Zahl der angeschlossenen Teilnehmerzahl ausgestattet ist.

An diese Ausgänge werden wie bei einer Satelliten-Zwischenfrequenz-Sternverteilung fernsteuerbare Umsetzereinheiten mit fest eingestelltem Ausgangskanal angeschlossen. Jedem angeschlossenen Teilnehmer ist dabei ein bestimmter Ausgangskanal zugeordnet.

Der größte Nachteil dieser fernsteuerbaren Empfangseinheiten ist aber, daß ein wirkungsvoller Schutz der Privatsphäre preisgünstig nicht realisierbar ist. D.h. jeder Nachbar kann bei Kenntnis der Kanaltabelle des Verteilnetzes feststellen, welches Programm vom jeweiligen Teilnehmer eingeschaltet ist. Es versteht sich von selbst, daß dies höchst unerwünscht ist, weshalb derartige Anlagen in der Regel nicht eingesetzt werden, obwohl sie durchaus Vorteile besitzen, wie z. B. der Erhalt der Durchschleifstruktur, Preiswürdigkeit gegenüber kanalselektiver Aufbereitung und volle Programmvielfalt.

Zudem ist eine Gemeinschaftsantennenanlage beispielsweise aus der DE 40 12 657 A1 bekannt geworden. Die Anlage besitzt ein Verteilkabel, dessen Eingang mit den Ausgängen von Umsetzern verbunden ist. Den Umsetzern werden von einer Antenne Träger zugeführt, die mit Fernsehsignalfrequenzen moduliert sind. Jeder Umsetzer erzeugt aus einem wählbaren dieser Träger einen mit dem gleichen Fernsehsignal modulierten neuen Träger mit einer jeweils vorbestimmten Frequenz. Jeder Umsetzer und seine vorbestimmte Frequenz ist jeweils einem von mehreren Ausgängen des Verteilkabels zugeordnet. Bei dem Ausgang steht ein Fernsteuersender, der im betreffenden Umsetzer die Wahl des von der Antenne zugeführten Trägers steuert. Die Anlage benötigt nur so viele Umsetzer und muß über das Verteilkabel nur so viele neue Träger mit verschiedenen vorbestimmten Frequenzen übertragen, wie Ausgänge am Verteilkabel vorhanden sind. Trotzdem können an jedem der Ausgänge alle Fernsehsignale gewählt werden, mit denen die von der Antenne zugeführten Träger moduliert sind.

Schließlich ist aus der DE 93 06 499 U1 eine Schaltungsanordnung und eine Vorrichtung zum Betreiben einer Antennenempfangsvorrichtung mit wenigstens einer Empfangsantenne bekannt geworden, deren Antennenausgangssignale jeweils mehreren Empfangsteilnehmern über eine Verteilleitung einer Gemeinschafts-/Hausempfangsanlage zu geleitet werden. Dabei ist ferner vorgesehen, daß wenigstens ein ausgewählter Kanal in Abhängigkeit eines teilnehmerspezifischen Wählsignals auf die Verteilleitung schaltbar ist.

Demgegenüber ist es Aufgabe der vorliegenden Erfindung, eine verbesserte Satellitenempfangsanlage mit einer steuerbaren Kopfstation zu schaffen, die auf günstige Weise einen Schutz der Privatsphäre erlaubt. Mit anderen Worten soll gewährleistet werden, daß andere angeschlossene Teilnehmer sich nicht darüber informieren können, welche Programme andere angeschlossene Teilnehmer aktuell empfangen und zugeschaltet haben.

Die Aufgabe wird erfindungsgemäß entsprechend der im Anspruch 1 oder im Anspruch 2 angegebenen Merkmale gelöst.

In der vorliegenden Erfindung wird eine einfache Methode geschaffen, mittels der ein preiswerter Schutz der Privatsphäre ermöglicht wird. Dabei werden erfindungsgemäß alle Vorteile einer fernsteuerbaren Empfangseinheit beibehalten.

Das erfindungsgemäße Verfahren geht dabei davon aus, daß die einzelnen Empfangskanäle für die zugeschalteten Teilnehmer nach einem Zufallsverfahren (Random) zugeordnet werden. Andere angeschlossene Teilnehmer im Haus können dabei zwar feststellen, welche Programme insgesamt mittels der Empfangseinheiten empfangen werden, nicht aber, welcher Teilnehmer welches Programm aktuell eingeschaltet hat und sieht. Bei jedem Einschalten wird dem Teilnehmer im wahlfreien Zugriff ein Kanal zugewiesen und sein Empfangsgerät automatisch auf den entsprechenden Empfangskanal eingestellt oder zumindest eine Information abgegeben, die die Einstellung ermöglicht. Da mit jedem Einschalten eine neue Berechtigung vergeben werden kann, ist es für einen anderen Teilnehmer praktisch nicht möglich, die Kanalzuordnung der übrigen Teilnehmer festzustellen.

Zudem ist es in einer bevorzugten Ausführungsform der Erfindung ferner möglich zu gewährleisten, daß außer der fehlenden Zuordnung nur die selbstgewählte und eingestellte Kanalauswahl ein brauchbares Bild oder einen brauchbaren Radioempfang liefert.

Die Erfindung wird nachfolgend anhand von Ausführungsbeispielen näher erläutert. Dabei zeigen im einzelnen:
- Figur 1 :: einen schematischen Schaltplan einer erfindungsgemäßen Ausführungsform mit einer Ansteuerung durch einen Receiver ohne weitere Zusatzeinrichtung;
- Figur 2 :: eine der erfindungsgemäßen Umsetzereinheit vorgeschaltete Satellitenempfangsanlage;
- Figur 3 :: ein Figur 1 entsprechendes Ausführungsbeispiel, bei welchem die Ansteuerung mittels eines dem Receiver vorgeschalteten Umsetzers (Modem) mittels eines I²C-Busses erfolgt;
- Figur 4 :: ein zu Figur 1 und 3 abgewandeltes Ausführungsbeispiel, bei welchem die Ansteuerung mittels eines dem Receiver vorgeschalteten und mittels einer Fernbedienung bedienbaren Umsetzers erfolgt;
- Figur 5 :: eine entsprechende Schaltungsanordnung mit Verteilung im VHF-/UHF-Bereich, welche der in Figur 2 wiedergegebenen Schaltungsanordnung nachgeschaltet ist.

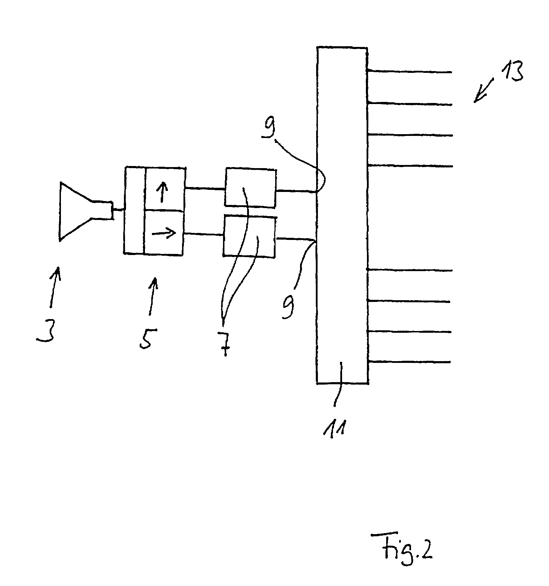

Figur 2 zeigt eine der erfindungsgemäßen Umsetzereinheit vorgeschaltete Satellitenempfangsanlage mit einem einer Satellitenantenne zugeordneten Speisesystem 3, eine diesem nachgeschaltete Polarisationsweiche 5 sowie beispielsweise zwei Konverterschaltungen 7 (LNB, LNC etc.) in dem jeweiligen Empfangszweig zum Empfang der vertikalen wie horizontalen Polarisationen.

Die beiden Ausgänge der beiden Zweige zum Empfang der vertikalen wie horizontalen Polarisationen stehen mit Eingängen 9 einer Umschalteinheit 11 in Verbindung.

Sollen beispielsweise auch zusätzlich noch links oder rechts zirkularpolarisierte Wellen empfangen werden, so werden unter Berücksichtigung der hierfür üblichen Eingangsschaltungen an der Umschalteinheit 11 vier Eingänge 9 vorgesehen sein, nämlich zum Empfang einmal der vertika1, der horizontal, der links und der rechts polarisierten Wellen. Ebenso könnte die Zahl der Eingänge an der Umschalteinheit 11 zunehmen, wenn beispielsweise Programme von verschiedenen Satelliten über mehrere Satellitenantennen oder beispielsweise von einem Multifeed-Speisesystem empfangen werden sollen.

Bei der Umschalteinheit 11 handelt es sich um eine X:Y-Umschalteinheit, wobei "X" die Zahl der Eingänge und "Y" die Zahl der Ausgänge betrifft, die zumindest der Zahl der angeschlossenen Teilnehmer entspricht.

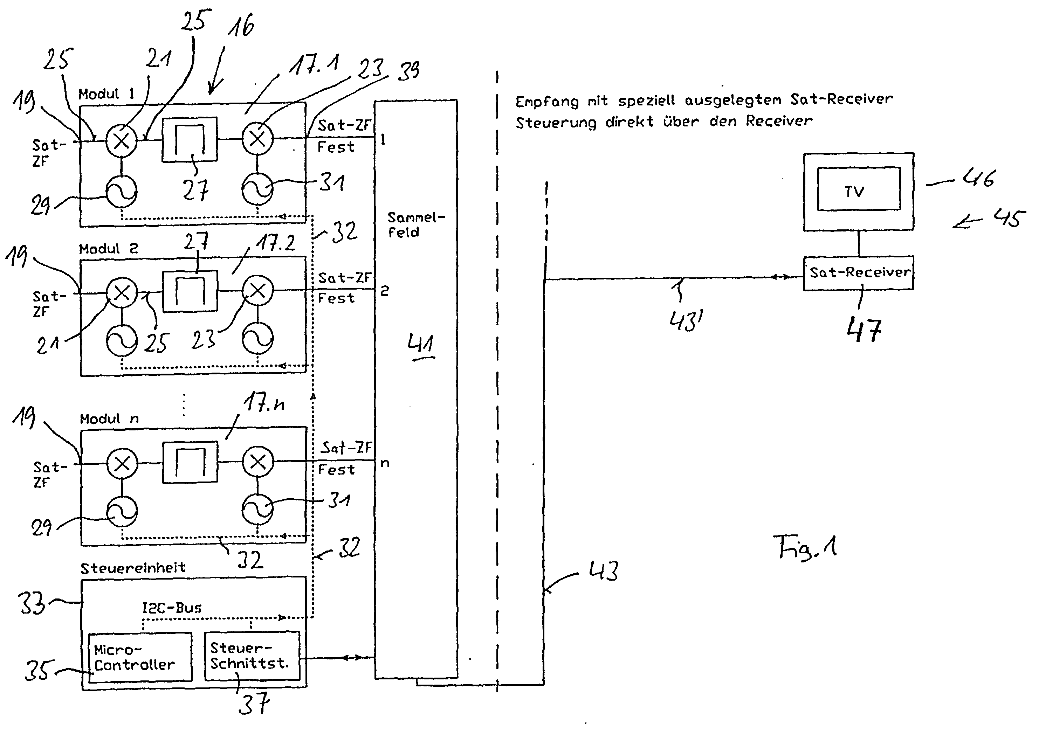

An die in Figur 2 gezeigten Ausgänge 13 wird die bei einer Satelliten-Zwischenfrequenz-Sternverteilung fernsteuerbare Umsetzereinheit 16 (fernsteuerbare Kopfstation 16) mit fest eingestellten Ausgangskanälen angeschlossen, wie dies anhand von Figur 1 gezeigt ist. D.h. jeder Eingang 19 der in Figur 1 gezeigten Umsetzereinheiten 17 ist mit der Umschalteinheit 11 gemäß Figur 2 verbunden.

Die Umsetzereinheit 16 umfaßt danach also n-Umsetzer-Module 17, die jeweils einen ersten Mischer 21 und einen zweiten Mischer 23 mit einem in der Empfangsleitung 25 dazwischen angeordneten Filter 27 (SAW-Filter). Der erste bzw. zweite Mischer 21, 23 wird jeweils über einen Lokaloszillator (PLL) 29 bzw. 31 angesteuert.

Die Steuerung erfolgt über einen Daten- oder Steuerungsbus 32, und zwar mittels einer Steuereinheit 33, die über einen Mikrocontroller 35, also einen Mikroprozessor, sowie beispielsweise eine entsprechende Steuerschnittstelle 37 verfügt.

Den Ausgängen 39 der Umsetzermodule 17 ist ein sog. Sammelfeld 41 nachgeschaltet, worüber die über die einzelnen Umsetzermodule 17 empfangenen Signale auf eine gemeinsame Übertragungsleitung 43 zu den einzelnen angeschlossenen Teilnehmern 45 übertragen werden. In Figur 1 ist lediglich einer der an einer von der Übertragungsleitung 43 abzweigenden Zweigleitung 43' angeschlossene Teilnehmer 45 mit einem Satellitenreceiver 45 gezeigt.

Über die oben erwähnte Steuereinheit 33 wird letztlich auch der Datenaustausch zwischen den angeschlossenen Teilnehmern 45 und der Empfangseinheit gemäß Figur 2 (also den Konvertern etc.) sowie die Umsetzereinheiten 17 einschließlich der Umschalteinheit 11 u. a. auch zur Auswahl der Polarisationen gesteuert, wobei der betreffende, dem einzelnen Teilnehmer zugeteilte Ausgangskanal dann dem Teilnehmer auch übermittelt wird.

Nachfolgend wird auf die Funktionsweise näher eingegangen. Wird davon ausgegangen, daß alle Teilnehmer 45 abgeschaltet sind, so kann die Funktionsweise derart sein, daß beim Einschalten eines Empfängers 47, also der in Figur 1 gezeigten Konverter, über den Mikroprozessor oder -controller 35 allen Teilnehmern oder zumindest dem aktuell zugeschalteten Teilnehmer nach dem Zufallsprinzip ein bestimmter Ausgangskanal 39, also ein bestimmtes Umsetzmodul 17 der n-Module 17 zugewiesen wird.

Würde beispielsweise der in Figur 1 gezeigte angeschlossene Teilnehmer 45 seinen Fernseher 46 zuschalten, so könnte ihm über den Mikroprozessor das Umsetzermodul 17.2 zugeordnet werden.

Dabei können die Umsetzermodule 17, d.h. deren Lokaloszillatoren, so eingestellt sein, daß die einzelnen Module entsprechend der Bandbreite der Filter 27 die teilnehmerseitig ausgewählten Programme in folgende Kanäle bzw. Kanalbreiten in das Sammelfeld einspeisen:

| | |
|---|---|
| Modul 17.1 | 950 - 980 MHz |
| Modul 17.2 | 990 - 1.020 MHz |
| Modul 17.3 | 1.030 - 1.060 MHz |
| u.s.w. | |
| Modul 17.n | 1.550 - 1.580 MHz |

Wird also beispielsweise davon ausgegangen, daß an den Eingängen 19 der Umsetzermodule 17 in der Zwischenfrequenz (ZF)-Ebene die von den Satelliten empfangenen Programme in einem Frequenzband von 950 MHz bis 2.050 MHz anstehen, und der erwähnte Teilnehmer 45 nunmehr ein Satellitenprogramm empfangen will, welches in der ZF-Ebene in dem Kanal von 1.250 MHz bis 1.280 MHz ansteht, so wird der erste Lokaloszillator 29 auf eine Frequenz von 1.743,25 MHz und der zweite Lokaloszillator 31 auf eine Mischerfrequenz von 1.483,25 MHz eingestellt, so daß unter Berücksichtigung des Filters 27 nunmehr am Ausgang 39 das so ausgewählte Programm mit der bezüglich des Moduls 17.2 fest eingestellten Satelliten-Zwischenfrequenz (SatZF) von 990 bis 1.020 MHz in das Sammelfeld 41 eingespeist wird.

Über den Satelliten-Receiver 47 vorgewählt und damit letztlich über die Steuereinheit 33 gesteuert, wird also der jeweilige Receiver nach dem Zufallsprinzip einem stets anderen Modul zugeschaltet - im erläuterten Ausführungsbeispiel das Umsetzermodul 17.2 - so eingestellt, daß das receiverseitig ausgewählte Programm in die in diesem Modul fest eingestellte Ausgangs-Satelliten-Zwischenfrequenz von beispielsweise 990 bis 1.020 MHz umgesetzt wird.

Schaltet sich ein nächster Teilnehmer ein, so wird diesem ebenfalls wieder nach dem Zufallsprinzip über den Mikroprozessor 35 ein nächstes der n vorgesehenen Umsetzermodule 17 zugeordnet.

Da gleichzeitig über den Mikroprozessor 35 die entsprechenden Daten auch an den Receiver übermittelt werden, kann über diesen Receiver stets nur die über das ihm zugeordnete Umsetzermodul 17 eingestellte Programm empfangen werden. Rückschlüsse, welche Teilnehmer welche weiteren Programme empfangen, d.h. eine Zuordnung, welcher Teilnehmer welches Programm empfängt, ist nicht möglich.

Bei Satelliten-Receivern 47 (Empfängern) mit zugeordneten Empfängerumsetzern werden also die Lokaloszillatoren 29, 31 über die Steuereinheit 33 automatisch eingestellt und somit die Zuordnung von gesteuertem und empfangenem Kanal hergestellt.

Unabhängig von dem vorstehend erläuterten Randomverfahren muß die dem Zufallsprinzip unterliegende Zuordnung der einzelnen Übertragungskanäle an die einzelnen Teilnehmer nicht zwingend zum Zeitpunkt des Einschaltens gestartet werden. Ein günstiger Zeitpunkt liegt beispielsweise dann vor, wenn alle Teilnehmer abgeschaltet sind. Eine Zufallsvergabe kann aber auch stets dann durchgeführt werden, wenn sich ein neuer Teilnehmer zuschaltet, wobei dann aus der Gruppe der einzelnen Teilnehmer noch nicht zugeordneten Umsetzermodulen 17 entsprechend dem Zufallsprinzip ein nächstes Umsetzermodul 17 dem jeweils nächsten zugeschalteten Teilnehmer zugeordnet wird.

In einer alternativen Ausführungsform ist es aber auch möglich, daß die einzelnen Teilnehmer 45 einer festen, stets gleichbleibenden Umsetzereinheit zugeordnet bleiben, beispielsweise der in Figur 1 dargestellte Teilnehmer 45 (Satellitenreceiver 47) stets dem Umsetzermodul 17.2 zugeordnet ist und bleibt. In diesem Falle könnten nach dem Zufallsprinzip über die Steuereinheit 33, d.h. den Mikroprozessor 35, gesteuert die Lokaloszillatoren 29, 31 automatisch so angesteuert werden, daß die Ausgangskanäle nach dem Zufallsprinzip beispielsweise auf die vorstehend wiedergegebenen Ausgangskanal-Breiten nicht fest eingestellt, sondern jeweils nach dem Zufallsprinzip unterschiedlich eingestellt werden. Auch in diesem Falle ist es anderen angeschlossenen Teilnehmern nicht möglich festzustellen, welcher Teilnehmer gegenwärtig welche Programme empfängt.

In dem geschilderten Ausführungsbeispiel gemäß Figur 1 und 2 erfolgt keine Modulationswandlung, sondern lediglich eine Umsetzung der ausgewählten Eingangskanäle in einem fest definierten Ausgangskanal. Die Orientierung über die eingestellten Programme wird durch den Satelliten-Receiver 47 vorgenommen, wenn dieser entsprechend wie in Figur 1 schematisch dargestellt ist, ausgerüstet ist. Receiver 45 mit entsprechender Ausrüstung können die Steuerung im Zusammenspiel mit der Steuereinheit 33 ohne eine Zusatzeinrichtung vornehmen. Neuartige Steuerungssysteme wie DiSEqC sind hier sehr gut geeignet.

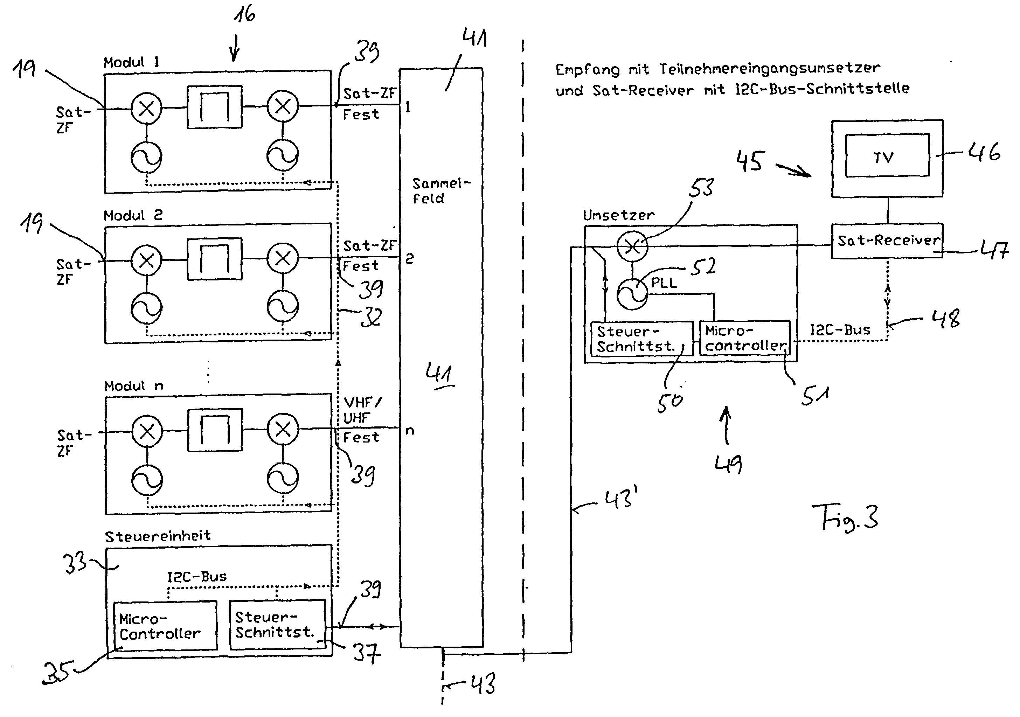

Andernfalls kommt eine Schaltung gemäß Figur 3 in Betracht, bei welcher die Einstellung der Programme beispielsweise mittels eines dem Receiver 47 vorgeschalteten Modems 49 (Umsetzer 49) möglich ist, wobei die Ansteuerung des Modems 49 vom Satelliten-Receiver 47 über einen I²C-Bus 48 erfolgen kann.

Gemäß dem Ausführungsbeispiel nach Figur 3 ist vorgesehen, daß dabei das Modem 49 eine interne Steuerschnittstelle 50 umfaßt, worüber über die Leitung 43' und die Übertragungsleitung 43 die Datenkommunikation mit der in der steuerbaren Kopfstelle 16 vorgesehenen Steuereinheit 33 erfolgt. Ferner umfaßt das Modem 49 gemäß Figur 3 einen Mikrokontroller 51, der einen in dem Modem 51 integrierten Lokaloszillator (PLL) 52 ansteuert, der wiederum den im Modem 50 integrierten Mischer 53 ansteuert, worüber das jeweils ausgewählte Programm auf die für den Empfang des Satellitenprogramms geeignete UHF-/VHF-Empfangsfrequenz umgesetzt wird.

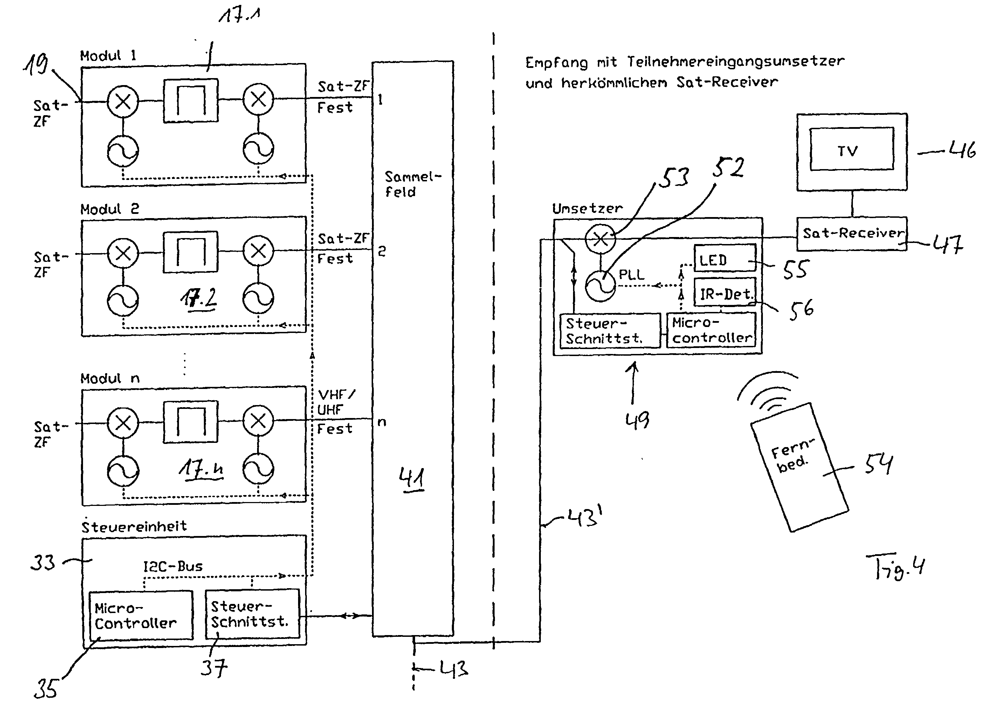

Ist der Receiver 47 nicht entsprechend wie in Figur 3 ausgestaltet, so kommt eine Ansteuerung des erwähnten Modems 49 - wie in Figur 4 dargestellt ist - mittels einer Fernbedienung 54 in Betracht.

Durch das jeweilige Modem 49 erfolgt also dann die Umsetzung der Satelliten-Zwischenfrequenz auf die für den Fernsehempfang geeignete UHF-/VHF-Empfangsfrequenz.

Der in Figur 4 erläuterte Umsetzer 49 umfaßt im Falle einer Fernbedienung beispielsweise noch eine LED-Anzeige 55 und einen Infrarot-Detektor 56, worüber angezeigt wird, wenn die Fernbedienung 54 aktiviert ist.

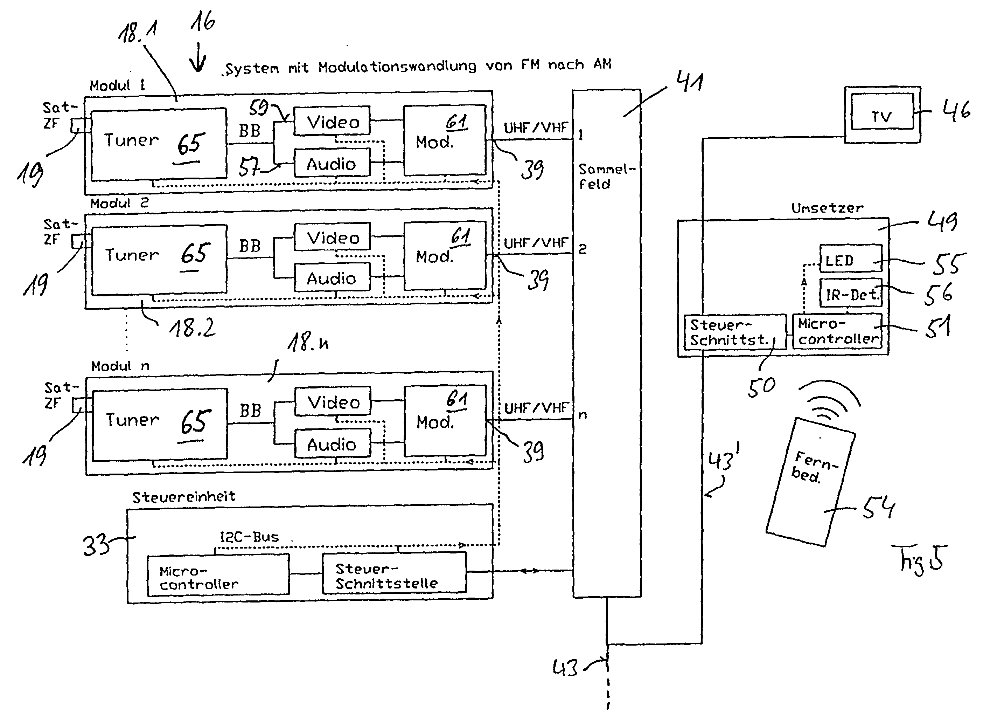

Alternativ zu den erläuterten Ausführungsbeispielen ist es gemäß Figur 5 aber auch möglich, daß eine Verteilung bereits im VHF-/UHF-Bereich erfolgt.

Die in dem Ausführungsbeispiel gemäß Figur 5 gezeigte Umsetzereinheit oder fernsteuerbare Kopfstation 16 umfaßt vier Umsetzermodule 18.1 bis 18.n, an deren Eingängen 19 ebenfalls wieder die Satelliten-Zwischenfrequenz ansteht.

Die Umsetzermodule 18 umfassen danach aber jeweils eingangsseitig einen Tuner 65 und einen Video-Zweig 57 sowie einen Audio-Zweig 59 zur Umsetzung der Bild- und der Tonsignale.

Der Video-Zweig 57 und der Audio-Zweig 59 sind ausgangsseitig mit einem Modem 61 verbunden, in welchem eine Umsetzung von der Satelliten-Zwischenfrequenz in den VHF-/VHF-Frequenzbereich erfolgt.

Die Ausgänge 39 dieser Umsetzermodule 18 können nunmehr so eingestellt sein, daß an den einzelnen Ausgängen der Module folgende Frequenzen anstehen:

| | |
|---|---|
| Modul 18.1 | 230 - 260 MHz |
| Modul 18.2 | 270 - 300 MHz |
| Modul 18.4 | 310 - 370 MHz |
| u.s.w. | |
| Modul 18.n | 830 - 860 MHz |

Ansonsten erfolgt die Steuerung wie anhand von Figur 3 erläutert, wonach die in den VHF-/UHF-Bereich umgesetzten und von den einzelnen Teilnehmern ausgewählten empfangenen Programme wiederum über ein Sammelfeld 41 und eine nachgeschaltete Übertragungsleitung 43 mit davon abzweigenden Zweigleitungen 43' den einzelnen Empfänger 45 gegebenenfalls unter Zuvorschaltung eines Modems 49 übertragen werden.

Bei dem Ausführungsbeispiel gemäß Figur 5 wird also in Abweichung zu den Ausführungsbeispielen gemäß Figur 1 oder 3 und 4 eine Modulationsumwandlung in den VHF-/UHF-Bereich vorgenommen. Dadurch kann die Installation unverändert bleiben, wobei auch die Steckdosen nicht getauscht werden müssen. Ein Umsetzer beim Teilnehmer übernimmt die Umsetzung in einen festen Satelliten-Zwischenfrequenz-Kanal und die Signalisierung und Modemfunktion für die Fernsteuerung der Empfangskanäle. Die Einstellung der richtigen Ausgangsfrequenz wird automatisch vorgenommen, wobei die Lokaloszillator-Frequenz des Umsetzers durch den Controller der Umsetzereinheit ferngesteuert wird. Die Teilnehmerreceiver werden für alle Programmplätze auf die gleiche Satelliten-Frequenz eingestellt. Dadurch ändert sich an den Programmauswahlgewohnheiten der Teilnehmer nichts, die vorprogrammierten Programmzuordnungen bleiben erhalten, wobei die OSD-Einblendungen weiterhin stimmen.

Aus den oben erläuterten Ausführungsbeispielen geht hervor, daß die nachfolgend auch als Teilnehmereingangsumsetzer bezeichneten Modems 49 je nach Anwendung und Ausstattung einen Infrarotempfänger, einen Anschluß für einen I²C-Bus 48 und/oder eine Empfangseinheit für DiSEqC-Signale, eine LED-Anzeige 55 zur Anzeige der eingestellten Programme bzw. für die Signalisierung des Empfangskanals umfassen. Ein Mikroprozessor 51 übernimmt die Synchronisation des notwendigen Datentransports für die Lokaloszillatoren 52 bei den Teilnehmereingangs-Umsetzern -Umsetzern 49 und die Signalisierung beim Einschalten des Empfängers (Sat-Receiver 47) zum Starten des nach dem Zufallsprinzip arbeitenden "Random-Verfahrens" in den Haupt- oder Umsetzereinheiten, die allgemein auch als Kopfstation 16 bezeichnet werden. Bei Teilnehmer-Eingangsumsetzern 49 mit Infrarotempfänger können durch Umschalten des Befehlssatzes verschiedene Receivertypen berücksichtigt werden. Hier muß speziell auf unterschiedliche Toggelfunktionen Rücksicht genommen werden. Der Befehlssatz eines solchen Empfängerumsetzers hat natürlich einen eingeschränkten Befehlsvorrat.

Im Zusammenspiel insbesondere mit den erwähnten empfängerseitigen Umsetzern 49 sind Receiver 47 zu verwenden, die entsprechend ausgestattet sind. Receiver, die mit DiSEqC ausgerüstet sind, können prinzipiell Umsetzer 49 steuern, wenn der Satelliten-Receiver 47 die vollen DiSEqC-Möglichkeiten unterstützt. Bei Steuerungssystemen DiSEqC ist es z. B. vorgesehen, die Lokaloszillator-Frequenz der Konverter - die in diesem Falle natürlich ebenfalls mit dem DiSEqC-Steuerungssystem ausgerüstet sein müssen - an den Satelliten-Empfänger 47 zu melden und den Empfänger 47 dann automatisch entsprechend der Lokaloszillator-Frequenz einzustellen. Bei einem Empfänger 47 mit entsprechender Ausstattung braucht man bei Verteilung in der ersten Satelliten-Zwischenfrequenz (1. Sat-ZF) kein Eingangsmodem bzw. keinen Eingangsumsetzer 47, wie die in dem Ausführungsbeispiel anhand von Figur 1 dargestellt ist, und hat trotzdem den vollen Bedienungskomfort.

Ferner sind Satelliten-Empfänger 47 bekannt, die einen Data-I/O-Eingang aufweisen. Bei entsprechender Ausgestaltung der Software des Empfängers 47 kann dieser Data-I/O-Eingang zur Steuerung des Umsetzers 47 bzw. der Umsetzereinheit 16 verwendet werden. Die Notwendigkeit einer zusätzlichen Fernbedienung entfällt. Der Empfänger 47 kann mit dem Umsetzer, d.h. dem Modem 47, Daten austauschen. Schließlich ist auch eine Änderung der Lokaloszillator-Frequenzeintragung beim Empfänger 47 möglich. Die Einstellung der notwendigen Frequenz beim Empfänger 47 würde dann automatisch erfolgen.

Schließlich ist aber auch die Verteilung zusätzlicher terrestischer Programme möglich. Werden beispielsweise UHF-Frequenzen für Übertragungen terrestischer Programme bei dem Ausführungsbeispiel gemäß Figur 5 benötigt, so kann man die entsprechenden Kanäle der FM-Verteilung sperren.

Der Vollständigkeit halber wird auch angemerkt, daß ein gutes Bild bzw. ein guter Ton nur in den Ausführungsbeispielen erzielbar ist, in denen ein teilnehmerseitiger Umsetzer 49 vorgesehen ist. Mit anderen Worten liefert also nur die selbstgewählte und eingestellte Kanalauswahl ein brauchbares Bild und einen brauchbaren Radioempfang. Auch dadurch wird das erfindungsgemäße Konzept unterstützt, wonach andere angeschlossene Teilnehmer nicht feststellen können, welche Programme andere angeschlossene Teilnehmer gerade empfangen.

Abschließend wird noch angemerkt, daß es sich bei dem vorstehend erläuterten Steuerungssystem DiSEqC um ein an sich bekanntes Steuerungssystem "Digital Satellite Equipment Control", also ein digitales Satellitenempfangs-Gerätesteuerungssystem, handelt.

## Patentansprüche

1. Satelliten-Empfangsanlage mit steuerbarer Kopfstation mit folgenden Merkmalen:
- mit einer Umsetzereinheit (16) mit mehreren Umsetzermodulen (17, 18),
- an den Eingängen (19) der Umsetzermodule (17, 18) stehen die von der Satellitenempfangsanlage empfangenen Programme in einer geeigneten Frequenz-Ebene an,
- die Ausgänge (39) der Umsetzermodule (17, 18) sind über ein Ausgangs-Sammelfeld (41) und eine nachfolgende Leitung (43) mit mehreren Teilnehmern (45) verbunden
- die Umsetzereinheit (16) umfaßt ferner eine Steuereinheit (33) mit einem Mikrokontroller (35) zur Ansteuerung der Lokaloszillatoren (21, 23) in den Umsetzermodulen (17) oder zur Ansteuerung der Tuner (65) und/oder Module (61) für die Umsetzermodule (18) im Falle einer Modulationswandlung,
**gekennzeichnet durch** die folgenden weiteren Merkmale
- die einzelnen Teilnehmer (45) erhalten spätestens bei Zuschaltung einen beliebigen Empfangsumsetzer (17, 18) und damit dessen Ausgangskanal (39) sowie eine Steuerungsmöglichkeit für diesen Empfangsumsetzer (17, 18) nach einem Zufalls-Verteilverfahren zugeordnet.

2. Satelliten-Empfangsanlage mit steuerbarer Kopfstation mit folgenden Merkmalen:
- mit einer Umsetzereinheit (16) mit mehreren Umsetzermodulen (17, 18),
- an den Eingängen (19) der Umsetzermodule (17, 18) stehen die von der Satellitenempfangsanlage empfangenen Programme in einer geeigneten Frequenz-Ebene an,
- die Ausgänge (39) der Umsetzermodule (17, 18) sind über ein Ausgangs-Sammelfeld (41) und eine nachfolgende Leitung (43) mit mehreren Teilnehmern (45) verbunden
- die Umsetzereinheit (16) umfaßt ferner eine Steuereinheit (33) mit einem Mikrokontroller (35) zur Ansteuerung der Lokaloszillatoren (21, 23) in den Umsetzermodulen (17) oder zur Ansteuerung der Tuner (65) und/oder Module (61) für die Umsetzermodule (18) im Falle einer Modulationswandlung, **dadurch gekennzeichnet, daß** die einzelnen Teilnehmer (45) einzelnen Umsetzermodulen (17, 18) fest zugeordnet sind, und daß nach dem Zufallsprinzip-Verfahren die Ausgangskanal-Frequenzen stets unterschiedlich eingestellt und die empfängerseitigen Anschlußgeräte (46, 47, 49) hierauf abgestimmt werden.

3. Satelliten-Empfangsanlage nach Anspruch 1 oder 2, **dadurch gekennzeichnet, daß** die Steuereinheit (33) den dem einzelnen Teilnehmer (45) zugewiesenen Ausgangskanal (39) zur automatischen Einstellung eines Lokaloszillators (52) und damit eines zugehörigen Mischers (53) beim teilnehmerseitigen Umsetzer (49) meldet, um am teilnehmerseitigen Receiver (47) oder einem angeschlossenen Empfangsgerät (46) einen festen Empfangskanal bzw. eine feste Empfangsfrequenz unabhängig vom Eingangskanal- und Ausgangskanal (19, 39) der Umsetzermodule (17, 18) der Umsetzeinheit (16) einzustellen.

4. Satelliten-Empfangsanlage nach einem der Ansprüche 1 bis 3, **dadurch gekennzeichnet, daß** die Steuerung durch die Empfänger (45) initialisiert und der Ablauf der Steuerung mittels der in der Umsetzereinheit (16) integrierten Steuereinheit (33) erfolgt.

5. Satelliten-Empfangsanlage nach einem der Ansprüche 1 bis 4, **dadurch gekennzeichnet, daß** den Empfängern ein Teilnehmer-Eingangsumsetzer (49) mit einem Mischer (53) und einem Lokaloszillator (52) vorgeschaltet ist, der über einen Mikro-Kontroller (51) angesteuert wird.

6. Satelliten-Empfangsanlage nach Anspruch 5, **dadurch gekennzeichnet, daß** der Mikro-Kontroller (51) in dem Teilnehmer-Eingangsumsetzer (49) über den Satelliten-Receiver (47) angesteuert wird.

7. Satelliten-Empfangsanlage nach Anspruch 5 oder 6, **dadurch gekennzeichnet, daß** die Ansteuerung des Mikro-Kontrollers (51) über den Satelliten-Receiver (47) über einen I²C-Bus (48) durchgeführt wird.

8. Satelliten-Empfangsanlage nach einem der Ansprüche 5 bis 7, **dadurch gekennzeichnet, daß** die Steuerung des Teilnehmer-Eingangsumsetzers (49) mittels einer Fernbedienung, insbesondere einer Infrarot-Fernbedienung (54) durchgeführt wird.

9. Satelliten-Empfangsanlage nach einem der Ansprüche 1 bis 6, **dadurch gekennzeichnet, daß** die Ansteuerung der in der Umsetzereinheit (16) vorgesehenen Steuereinheit (33), d.h. insbesondere des darin integrierten Mikro-Kontrollers (35) direkt über den teilnehmerseitig installierten Satelliten-Receiver (47) durchgeführt wird, insbesondere mittels eines Steuerungssystems DiSEqC oder dergleichen.

## Claims

1. Satellite receiving system having a controllable head station, with the following features:
- having a converter unit (16) with a number of converter modules (17, 18),
- the programs received by the satellite receiving system are applied at a suitable frequency level to the inputs (19) of the converter modules (17, 18),
- the outputs (39) of the converter modules (17, 18) are connected to a number of subscribers (45) via an output distributor (41) and a downstream line (43),
- the converter unit (16) furthermore has a control unit (33) with a microcontroller (35) for driving the local oscillators (21, 23) in the converter modules (17), or for driving the tuner (65) and/or modules (61) for the converter modules (18) in the case of modulation conversion,
**characterized by** the following further features:
- the individual subscribers (45) are allocated, at the latest on connection, a random reception converter (17, 18) and thus its output channel (39) as well as a control option for this reception converter (17, 18) on the basis of a random distribution method.

2. Satellite receiving system having a controllable head station, with the following features:
- having a converter unit (16) with a number of converter modules (17, 18),
- the programs received by the satellite receiving system are applied at a suitable frequency level to the inputs (19) of the converter modules (17, 18),
- the outputs (39) of the converter modules (17, 18) are connected to a number of subscribers (45) via an output distributor (41) and a downstream line (43),
- the converter unit (16) furthermore has a control unit (33) with a microcontroller (35) for driving the local oscillators (21, 23) in the converter modules (17), or for driving the tuner (65) and/or modules (61) for the converter modules (18) in the case of modulation conversion, **characterized in that** the individual subscribers (45) are permanently allocated to individual converter modules (17, 18), and **in that** the output channel frequencies are always set differently on the basis of the random principle method, and the receiver-end connecting appliances (46, 47, 49) are tuned thereto.

3. Satellite receiving system according to Claim 1 or 2, **characterized in that** the control unit (33) signals the output channel (39) which is assigned to the individual subscriber (45) for automatic setting of a local oscillator (52) and hence of an associated mixer (53) in the subscriber-end converter (49), in order, at the subscriber-end receiver (47) or at a connected receiving appliance (46), to set a fixed reception channel or a fixed reception frequency independently of the input channel and output channel (19, 39) of the converter modules (17, 18) of the conversion unit (16).

4. Satellite receiving system according to one of Claims 1 to 3, **characterized in that** the controller is initialized by the receiver (45), and the control sequence is governed by the control unit (33) which is integrated in the converter unit (16).

5. Satellite receiving system according to one of Claims 1 to 4, **characterized in that** a subscriber input converter (49) with a mixer (53) and a local oscillator (52) is positioned upstream of the receivers, and is driven via a microcontroller (51).

6. Satellite receiving system according to Claim 5, **characterized in that** the microcontroller (51) in the subscriber input converter (49) is driven via the satellite receiver (47).

7. Satellite receiving system according to Claim 5 or 6, **characterized in that** the microcontroller (51) is driven via an I²C bus (48), via the satellite receiver (47).

8. Satellite receiving system according to one of Claims 5 to 7, **characterized in that** the subscriber input converter (49) is controlled by means of a remote control, in particular an infrared remote control (54).

9. Satellite receiving system according to one of Claims 1 to 6, **characterized in that** the control unit (33) which is provided in the converter unit (16), that is to say in particular the microcontroller (35) which is integrated in it, is driven directly via the satellite receiver (47) installed at the subscriber end, in particular by means of a DiSEqC control system, or the like.

## Revendications

1. Installation de réception de satellite avec une station de tête susceptible d'être commandée, comportant les éléments suivants :
- une unité convertisseur (16) comportant plusieurs modules convertisseurs (17, 18),
- les programmes reçus par le récepteur satellite sont appliqués au niveau des entrées (19) des modules convertisseurs (17, 18) dans un plan de fréquences approprié,
- les sorties (39) des modules convertisseurs (17, 18) sont reliées à plusieurs utilisateurs (45) via un champ collectif de sortie (41) et via une ligne successive (43),
- l'unité convertisseur (16) comprend en outre une unité de commande (33) comportant un microcontrôleur (35) pour piloter les oscillateurs locaux (21, 23) dans les modules convertisseurs (17) ou pour piloter les tuners (65) et/ou les modules (61) pour les modules convertisseurs (18) en cas d'une transformation par modulation,
**caractérisée par** les autres éléments suivants :
- les utilisateurs individuels (45) reçoivent, au plus tard lors d'un branchement, un convertisseur récepteur quelconque (17, 18) et ainsi son canal de sortie (39) ainsi qu'une possibilité de commande pour ce convertisseur récepteur (17, 18) selon une méthode de distribution aléatoire.

2. Installation de réception de satellite avec une station de tête susceptible d'être commandée, comportant les éléments suivants :
- une unité convertisseur (16) comportant plusieurs modules convertisseurs (17, 18),
- les programmes reçus par le récepteur satellite sont appliqués au niveau des entrées (19) des modules convertisseurs (17, 18) dans un plan de fréquences approprié,
- les sorties (39) des modules convertisseurs (17, 18) sont reliées à plusieurs utilisateurs (45) via un champ collectif de sortie (41) et via une ligne successive (43),
- l'unité convertisseur (16) comprend en outre une unité de commande (33) comportant un microcontrôleur (35) pour piloter les oscillateurs locaux (21, 23) dans les modules convertisseurs (17) ou pour piloter les tuners (65) et/ou les modules (61) pour les modules convertisseurs (18) en cas d'une transformation par modulation, **caractérisée en ce que** des modules convertisseurs individuels (17, 18) sont associés de manière fixe aux utilisateurs individuels (45), et **en ce que** les fréquences de canal de sortie sont toujours réglées différemment selon la méthode de principe aléatoire et les appareils connectés (46, 47, 49) côté récepteur sont accordés à ces fréquences.

3. Installation de réception de satellite selon l'une ou l'autre des revendications 1 et 2, **caractérisée en ce que** l'unité de commande (33) annonce au convertisseur (49) côté utilisateur le canal de sortie (39) affecté à l'utilisateur individuel (45) pour le réglage automatique d'un oscillateur local (52) et ainsi d'un mélangeur associé (53), afin de régler au niveau du récepteur (47) côté utilisateur ou d'un appareil récepteur raccordé (46) un canal de réception fixe ou une fréquence de réception fixe indépendamment du canal d'entrée et du canal de sortie (19, 39) des modules convertisseurs (17, 18) de l'unité convertisseur (16).

4. Installation de réception de satellite selon l'une quelconque des revendications 1 à 3, **caractérisée en ce que** la commande est initialisée par les récepteurs (45) et le déroulement de la commande s'effectue au moyen de l'unité de commande (33) intégrée dans l'unité convertisseur (16).

5. Installation de réception de satellite selon l'une quelconque des revendications 1 à 4, **caractérisée en ce qu'**en amont des récepteurs est prévu un convertisseur d'entrée d'utilisateur (49) comportant un mélangeur (53) et un oscillateur local (52) qui est piloté via un microcontrôleur (51).

6. Installation de réception de satellite selon la revendication 5, **caractérisée en ce que** le microcontrôleur (51) dans le convertisseur d'entrée d'utilisateur (49) est piloté par le récepteur de satellite (47).

7. Installation de réception de satellite selon l'une ou l'autre des revendications 5 et 6, **caractérisée en ce que** le pilotage du microcontrôleur (51) est effectué par le récepteur de satellite (47) via un bus I²C (48).

8. Installation de réception de satellite selon l'une quelconque des revendications 5 à 7, **caractérisée en ce que** la commande du convertisseur d'entrée d'utilisateur (49) s'effectue au moyen d'une télécommande, en particulier d'une télécommande infrarouge (54).

9. Installation de réception de satellite selon l'une quelconque des revendications 1 à 6, **caractérisée en ce que** le pilotage de l'unité de commande (33) prévue dans l'unité convertisseur (16), c'est-à-dire en particulier du microcontrôleur (35) intégré dans celle-ci, est effectué directement par le récepteur de satellite (47) installé du côté utilisateur, en particulier au moyen d'un système de commande DiSEqC ou similaire.
